# EUROPEAN PATENT SPECIFICATION

(11) **EP 2 058 277 B1**
(45) Date of publication and mention of the grant of the patent: **22.06.2011**
(21) Application number: 07254427.3
(22) Date of filing: 09.11.2007
(51) Int. Cl.: B81C 1/00, B63B 1/34, F15D 1/10

(54) **Apparatus with a surface having cells coupled to bubbles for enhanced drag reduction of a fluid and associated method**
Vorrichtung mit einer Oberfläche mit Zellen, die mit Blasen zu einer verbesserten Flusswiderstandsreduzierung einer Flüssigkeit verbunden sind, und zugehöriges Verfahren
Appareil avec une surface ayant des cellules couplées en bulles pour une réduction de traînée améliorée d'un fluide et procédé associé

(43) Date of publication of application: 13.05.2009
(73) Proprietor: LUCENT TECHNOLOGIES INC., Murray Hill, NJ 07974-0636 (US); University of Limerick, Limerick (IE)
(72) Inventor: Enright, Ryan, Longford Co. Longford (IE); Hodes, Marc Scott, Dublin 15 (IE); Kolodner, Paul Robert, Hudson NJ 07030 (US); Krupenkin, Thomas Nikita, Somerset NJ 07059 (US); Salamon, Todd Richard, Morris NJ 07928 (US); Taylor, Joseph Ashley, Union NJ 07081 (US)
(74) Representative: Sarup, David Alexander

(56) References cited:
- EP-A- 0 442 519
- EP-A1- 1 520 622
- WO-A-94/18946
- DE-A1- 3 601 035
- DE-U- 1 728 527

## Description

The present invention relates to the control of flow resistance of a fluid passing over a surface.

As is known by those skilled in the art, it is possible to reduce the flow resistance a fluid (liquid) is subjected to on a surface by means of nano-structures or micro-structures engineered on said surface. For instance, one may define i) a plurality of cells on the surface of a substrate, each having at least one dimension that is less than the capillary length, where the capillary length may range from several micrometers to several millimeters depending on the interfacial tension between the two fluids (i.e., liquid referred to above and medium discussed below) in contact, and comprising a lateral wall defining an open housing for holding a medium (gas and/or liquid) therein, and ii) a foam on the surface on which the drag reduction is desired. This foam comprises fluid walls contacting the cells, defining at least partly bubbles which are filled with the medium, and including a surfactant. This surfactant is intended for stabilizing the bubbles, i.e., preventing them not only from collapsing and disappearing, but also from growing or merging or else coalescing (which can block the channel through which the fluid is flowing).

Such a solution is notably described in patent application WO 2008/027330 A2. It offers interesting performance in terms of drag reduction, but spatial variations may appear in the concentration of the surfactant contained in the fluid walls defining the bubbles, which induce interfacial (Marangoni) stresses that locally increase the drag.

Published patent application EP 1520622 A1 discloses an array of cells which are formed on a surface for the purpose of reducing flow resistance.

The object of this invention is to improve, at least partly, the stabilization of the bubbles that are defined by the fluid walls of the foam which are in contact with the surface cells.

For this purpose, it provides an apparatus comprising, i) a plurality of cells disposed on a surface of a substrate, each of these cells comprising a lateral wall defining an open housing for holding a medium therein and having at least one dimension that is less than the capillary length of the fluid-medium combination, and ii) a foam situated at the boundary of the fluid and comprising fluid walls contacting the cells and defining at least partly bubbles filled with this medium. The fluid walls are made of fluid which separates the bubbles from each other.

This apparatus is **characterized in that** the fluid walls include dissolved molecules of at least one ionic salt intended to stabilize the bubbles.

The apparatus according to the invention may include additional characteristics considered separately or combined, and notably:
- each ionic salt may be chosen from a group comprising at least NaCl, CuSO₄, AlCl₃, MgSO₄, MgCl₂, CaCl₂, Na₂SO₄, LiCl, NaBr and KCI;
- the foam may comprise a quasi-static foam layer or a transient foam layer;
- the concentration of the ionic salt(s) is chosen so that, for the particular salt(s), fluid and geometry of interest, bubble stabilization is attained. For the case of NaCl, this concentration is preferably greater than or approximately equal to 0.18 mol/liter. Also note that this concentration may be dependent upon the bubble geometry;
- the substrate surface may comprise openings that couple each cell to a source of medium;
- the medium may be a gas and/or a liquid;
- the fluid may be a liquid.

The invention also provides a method for controlling the flow resistance of a fluid on a surface of a substrate, this surface comprising a plurality of cells each comprising a lateral wall defining an open housing for holding a medium therein and having at least one dimension that is less than the capillary length of the fluid-medium combination, this method consisting notably in defining a foam situated at the boundary of the fluid and comprising fluid walls contacting the cells and defining at least partly bubbles filled with this medium.

This method is **characterized in that** one also adds molecules of at least one ionic salt to the fluid in order that the fluid walls contain some of these added molecules, thus allowing stabilization of the bubbles.

The method according to the invention may include additional characteristics considered separately or combined, and notably :
- one may choose each ionic salt from a group that includes NaCl, CuSO₄, AlCl₃, MgSO₄, MgCl₂, CaCl₂, Na₂SO₄, LiCl, NaBr and KCI;
- one may define a foam comprising a quasi-static foam layer or a transient foam layer;
- in the case where the salt is NaCl, one may add a concentration of ionic salt(s) in the fluid which is greater than or equal to 0.18 mol/liter;
- one may feed each cell with the medium through openings defined into the substrate surface and coupled to a source of medium;
- one may use a medium which is a gas and/or a liquid;
- one may use a fluid which is a liquid.

Other features and advantages of the invention will become apparent on examining the detailed specifications hereafter and the appended drawings, wherein:
- figure 1 schematically illustrates, in a cross-sectional view, a first example of one embodiment of an apparatus according to the invention,
- figure 2 illustrates a plan view of the first example apparatus presented in figure 1,
- figure 3 is a partial two-dimensional (2D) confocal image of a plan view of an example of a foam, and
- figure 4 schematically illustrates, in a cross-sectional view, a second example of an embodiment of an apparatus according to the invention.

The appended drawings may serve not only to complete the invention, but also to contribute to its definition, if need be.

The invention aims at offering an apparatus, and the associated method, for controlling the flow resistance of a fluid over a surface by means of stabilized bubbles.

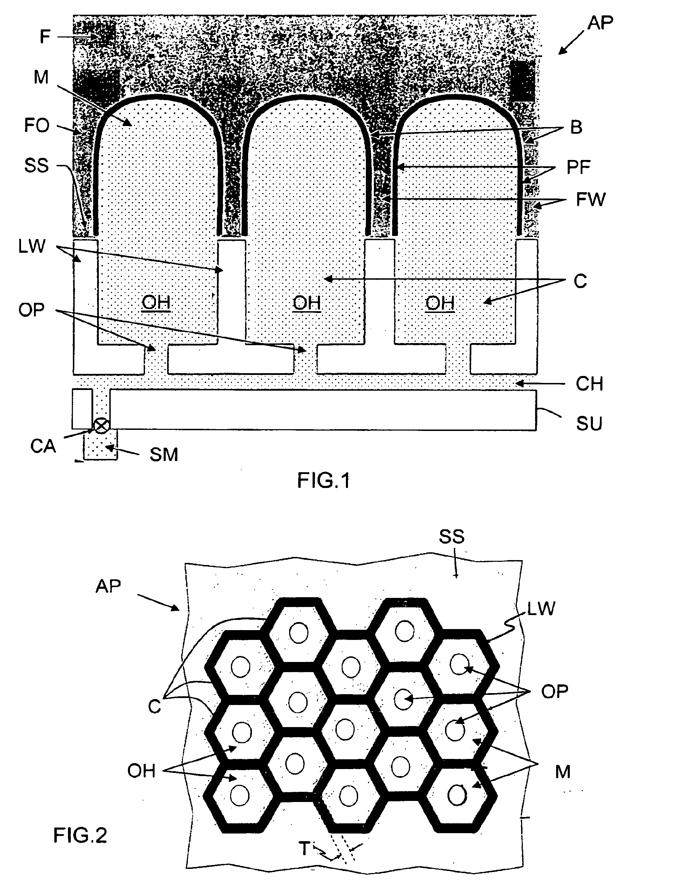

As schematically illustrated in figure 1, an apparatus AP according to the invention comprises at least a surface SS of a substrate SU on which micro-cells or nano-cells C are defined, a fluid F, a medium M and molecules of at least one ionic salt.

What one means here by "fluid" is a liquid, such as water or oil, for instance.

Moreover, what one means here by "medium" is a gas, such as nitrogen, air, argon, helium, carbon dioxide, hydrogen or oxygen, for instance, and/or a liquid, such as water, for instance.

For instance, it is possible to use a high viscosity liquid for the fluid F, such as an oil, and a low viscosity medium M, such as water. This could, for example, help induce drag reduction on the walls of an oil pipeline in the case where the medium is a liquid.

It is important to note that the invention applies not only if one uses a single ionic salt, such as sodium chloride (NaCl), copper sulphate (CuSO₄), AlCl₃, MgSO₄, MgCl₂, CaCl₂, Na₂SO₄, LiCl, NaBr or KCI, for instance, but also a combination of two or more different ionic salts.

As illustrated in figures 1 and 2, each cell C is fabricated on the surface SS of a substrate SU or a stack of substrates that are in contact with each other. The substrate SU can be planar and can comprise an inorganic semiconductor, such as silicon or silicon-on-insulator (SOI), for instance, or it can be non-planar and can comprise other materials, such as plastics or metals.

A cell C is a microstructure or nanostructure comprising a lateral wall LW defining an open housing (or volume) OH for holding a medium M therein. One means here by "microstructure or nanostructure" a structure having at least one dimension that is less than the capillary length of the fluid F - medium M combination (typically less than about one millimetre, and in some cases less than about one micron). This dimension can be the thickness T of the lateral wall LW (see figure 2). The cell (open) housings OH are said to be "open" because their "upper" face (perpendicular to the lateral walls LW) is not closed by a wall.

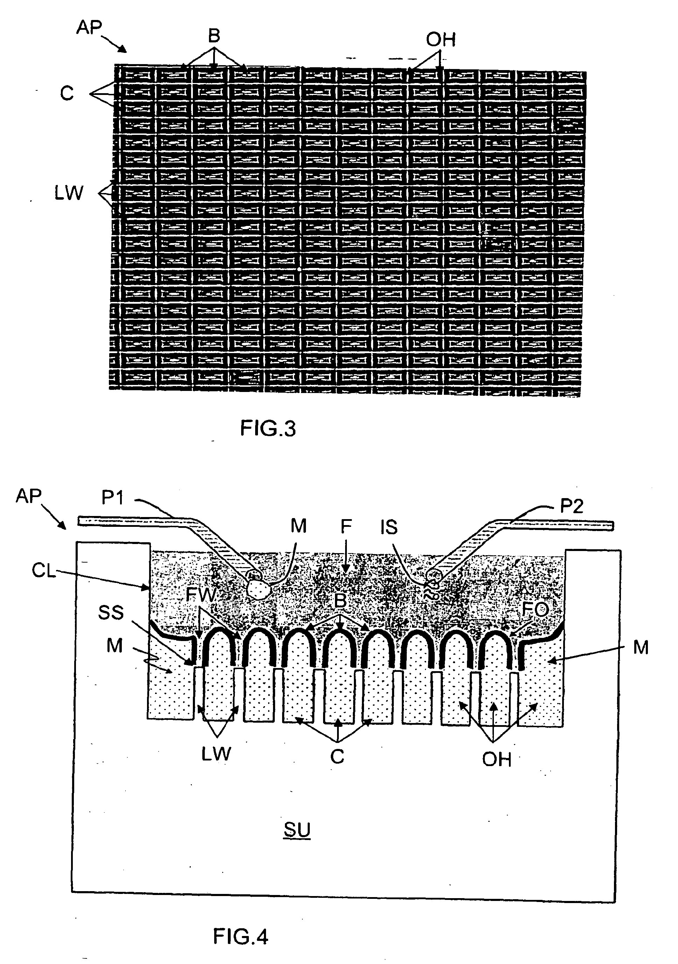

In the non-limiting embodiment illustrated in figure 2, all the cells C have the same hexagonal shape and share their lateral walls LW. But, in other embodiments, the cell shape can be circular or square or octagonal or else rectangular as in figure 3, and/or the cells C can have a polygonal shape, and/or the cells C can be independent structures that do not share their lateral walls LW. Moreover, the shapes and/or the dimensions of the cells C are not necessarily identical. They may vary from one cell to another. Identical shapes and dimensions ease manufacturing and may provide the surface SS with uniform wettability properties.

The cells C can be defined on the surface SS by any technique known by one skilled in the art, and notably by photolithographic and wet or dry etching procedures, or by drilling into the substrate SU, or else by a stamping, moulding or casting procedure.

According to the invention, one defines a foam FO bordering the fluid F (i.e., situated at the boundary of the fluid). This foam FO comprises fluid walls FW that contact the cells C and define at least partly bubbles B that are filled with the medium M. So, the fluid walls are made of a fluid which separates the bubbles B from each other.

These fluid walls FW include molecules of at least one ionic salt which stabilize the bubbles B. By "stabilize the bubbles" we mean prevent the bubbles B from collapsing and disappearing, but also from growing or merging or else coalescing.

The stabilization achieved by the addition of certain chosen ionic salt(s) relates to the retardation of bubble coalescence or merging, but the exact physical mechanism of this stabilization is not yet resolved. V.S.J. Craig has proposed an explanation in the document "Bubble coalescence and specific-ion effects" (Current opinion in Journal of Colloid & Interface Science, 9 (2004), pages 178-184, Elsevier). He suggests two competing theories to explain the mechanism. The first theory relates to the establishment of capillary waves at the fluid/medium interfaces of each bubble (i.e., the fluid wall (or film) FW) that meet to create a rupture in this fluid wall (or film) FW. The second theory contends that dissolved medium nucleation can be responsible for the rupture of the fluid wall (or film) FW separating adjacent bubbles B. So, based on these hypotheses, the ionic salt(s) could be capable of either suppressing (or notably reducing the intensity of) the capillary waves and/or retarding diffusion of dissolved medium in the fluid wall (or film) FW.

As illustrated in figure 1, at least a portion PF of each fluid wall FW contributing to the definition of a bubble B can be substantially parallel to the lateral wall LW of the cell C associated with this bubble. More precisely, the fluid walls FW project substantially orthogonally out from the substrate surface SS and continue the lateral walls LW of the cells C, so that these cells C are separated from the fluid F. But it is important to note that, in other embodiments, the bubbles B can be planar interfaces, spherically capped and/or elongated.

Depending on the chosen application, the foam FO can comprise a quasi-static foam layer or a transient foam layer located between the cells C and the fluid F. By "quasi-static foam layer", we mean a foam layer in which the bubbles B remain substantially stationary on the "top" of the cells C for an extended period. For instance, each bubble B remains attached to one cell C for at least about one minute, and in some cases about 15 minutes or more. Moreover, one means by "transient foam layer" a foam layer in which the bubbles B are attached to cells C for a brief period, for instance less than one minute, and in some cases less than one second.

It is important to note that the fluid F can be initially separated from the medium M and/or the ionic salt(s) or it can contain the medium M and/or the ionic salt(s) dissolved therein. In some cases, the formation of the foam FO depends upon having the medium M and the ionic salt(s) present in the fluid F. In particular, to form a quasi-static foam layer, it is important, and in some cases critical, to have a minimal concentration of ionic salt(s) and medium M in the fluid F.

The ionic salt concentration is necessary for minimizing bubble coalescence or bubble merging. This concentration varies depending on the type of ion combination(s). It should be noted that this combinatorial effect has been studied, specifically by R.R. Lessard and S.A. Zieminski in "Bubble coalescence and gas transfer in aqueous electrolytic solutions", Ind. Eng. Chem. Fundam., Vol. 10, N°2, 1971, pages 260-269, but it is not yet fully understood.

The concentration of the ionic salt(s) is chosen so that, for the particular salt(s), fluid F and geometry of interest, bubble stabilization is attained. This concentration may also be dependent upon the bubble geometry.

It can be demonstrated that, below a minimal concentration of ionic salt(s) in the fluid F, the likelihood of the bubbles B to coalesce or merge is significantly greater. This minimal concentration is approximately equal to 0.18 mol/liter for an aqueous solution of NaCl and may vary depending on the dimensions of the bubbles. So, the invention notably applies in case where the medium M is a gas, such as nitrogen or air, for instance, and the fluid F and ionic salt(s) are mixed together as is the case in the sea water (where concentration of NaCl (or salinity) is greater than 0.4 mol/liter).

The maximal concentration of salt is limited by its solubility in solvent (at high enough concentrations the salt precipitates out of the solvent).

As mentioned below, in some cases it is also important to have sufficient medium concentration in the fluid F to promote foam formation. In particular, in some embodiments, it is desirable for the concentration of medium M dissolved in the fluid F to exceed a certain critical pressure difference of medium M in the cells C.

The expression "critical pressure difference of the medium M dissolved in the fluid F" must be understood in terms of Henry's law or Raoult's law, according to which there is an associated equilibrium between the dissolved gas in the fluid and the gas adjacent to the fluid. It is important to note that the curvature of the interface impacts this equilibrium condition, particularly for small radii of curvature.

When the concentration of medium M in the fluid F exceeds this critical pressure difference, the bubbles B can be formed at the interface of fluid F and medium M, and they form the foam FO.

This critical pressure difference of the medium M in the cells C depends on the surface tension of the fluid F, as well as on the diameter of the cells C. More precisely, the critical pressure difference of the medium in the cells is given by the relation 2γ/r, where γ is the surface tension of the fluid and r is the radius of curvature of the smallest bubble B that the cell C is capable of accommodating (for a circular cell C, r is precisely its radius).

Each bubble B may have a diameter that is nominally equal to the diameter of the associated cell C, but this is not mandatory.

In some embodiments, the pressure of the medium M in the fluid F must be equal or greater than the critical pressure difference. This can be the case, for instance, when the medium M dissolved in the fluid F is in equilibrium with the medium in the cells C. However, in other cases, such as when the medium M is introduced into the cells C via openings OP (illustrated in the non-limiting example of embodiment of figure 1) defined into the surface SS in each cell C, the pressure of the medium M dissolved in the fluid F can be less than the critical pressure difference.

One will note that it can be undesirable to have an excessive amount of the medium M in the fluid F, typically an amount inducing a medium pressure exceeding the critical pressure difference by more than about 10%, because it can limit the formation of a quasi-static foam layer. Indeed, the ionic salt(s) is (are) no longer capable of stabilizing the size of the bubbles B, and therefore these bubbles B keep on growing until they merge and/or detach from the surface SS, causing the foam FO to break down. This process is typically known as Laplace-pressure instability or Ostwald ripening.

The addition of ionic salts does not decrease the critical pressure difference because ionic salts do not substantially affect surface tension.

As mentioned before and as illustrated in figure 1, the medium M can be introduced into the cells C via openings OP that are defined in the surface SS at the level of each cell C, for instance substantially in the middle of the cells C. Each opening OP couples its cell C to a source of medium SM. For instance, and as illustrated in figure 1, the source SM can comprise a chamber CH in connection with each opening OP and with a tank (not illustrated) through a control access means CA, such as a valve. This allows control and adjustment of the medium pressure, so that a suitable pressure difference can be maintained between the medium and the fluid.

The openings OP and/or the chamber CH can be defined in the surface SS by any technique known to those skilled in the art, and notably by photolithographic and wet or dry etching procedures, or by drilling into the substrate SU, or else by a printing, moulding or casting procedure.

In the embodiment illustrated in figure 1, the openings OP can also be used to introduce the ionic salt(s) into the cells C. For this purpose, the source SM can deliver the medium M mixed with the ionic salt(s) into the chamber CH.

In a first variant, the medium M can be introduced into the cells C through the openings OP, while the ionic salt(s) is (are) introduced into the fluid F either mixed (dissolved) or additionally by means of a conduit, such as a pipe.

In a second variant illustrated in figure 4, the medium M and the ionic salt(s) IS can be introduced into the fluid F either mixed (dissolved) or additionally by means of one or two conduits P1 and P2, such as pipes. In this case, no opening is defined into the surface SS. When the medium M is a gas, for instance air or nitrogen, a certain amount of this medium M is dissolved into the fluid F and diffuses into the cells C, inducing bubble formation and then the growth of the foam FO.

In the non-limiting example of embodiment illustrated in figure 4, the apparatus AP is a microfluidic device comprising a channel CL through which the fluid F is flowing. This channel CL can be defined at least partly into the substrate SU. But it can also be a detachable piece fixed onto the substrate SU.

In any case, the amounts (or concentrations) of medium M and ionic salt(s) can be controlled and adjusted in order to achieve a chosen reduction in fluid flow resistance (or drag), and a corresponding increase in fluid flow rate. It is important to note that the chosen reduction in fluid flow resistance can correspond to predetermined amounts (or concentrations) of medium M and ionic salt(s). But, in some cases, the amounts (or concentrations) of medium M and ionic salt(s) required to achieve a particular fluid flow resistance are not known. In such cases one or both of the amounts (or concentrations) of medium M and ionic salt(s) introduced into the fluid F can be incrementally adjusted while the fluid flow rate in the channel CL is monitored.

It is also possible to control the flow resistance of an apparatus AP, such as a vehicle or motor-driven on-water or underwater equipment or device, moving through a fluid F. In this case the apparatus AP has a body comprising an external surface SS covered at least partly with the cells C.

The invention can also be considered in terms of a method for controlling the flow resistance of a fluid F on a surface SS of a substrate SU, this surface SS comprising a plurality of cells C having at least one dimension that is less than the capillary length of the fluid F - medium M combination and each comprising a lateral wall LW defining an open housing OH for holding a medium M therein.

Such a method may be implemented by means of an apparatus AP such as the one above described with reference to the figures. Therefore, only its main characteristics will be mentioned hereafter.

The method according to the invention consists of defining, in the fluid F, a foam FO which comprises fluid walls FW i) comprising molecules of at least one ionic salt added to the fluid F and medium M, ii) contacting the cells C, and iii) defining at least partly bubbles B filled with the medium M.

The invention is not limited to the embodiments of method and apparatus described above, only as examples, but it encompasses all alternative embodiments which may be considered by one skilled in the art within the scope of the claims hereafter.

## Claims

1. Apparatus (AP) for controlling the flow resistance of a fluid passing over a surface, comprising a plurality of cells (C) disposed on a surface (SS) of a substrate (SU), each of said cells (C) comprising a lateral wall (LW) defining an open housing (OH) for holding a medium (M) therein and having at least one dimension that is less than the capillary length of a fluid-medium combination, **characterised in that** it comprises a foam (FO) situated at the boundary of a fluid (F) and comprising fluid walls (FW) contacting said cells (C) and defining at least partly bubbles (B) filled with said medium (M), wherein said fluid walls (FW) include dissolved molecules of at least one ionic salt for stabilising said bubbles (B).

2. Apparatus according to claim 1, **characterised in that** each ionic salt is chosen from a group comprising at least NaCl, CuSO₄, AlCl₃, MgSO₄, MgCl₂, CaCl₂, Na₂SO₄, LiCl, NaBr and KCl.

3. Apparatus according to one of claims 1 and 2, **characterised in that** said foam (FO) comprises a quasi-static foam layer.

4. Apparatus according to one of claims 1 and 2, **characterised in that** said foam (FO) comprises a transient foam layer.

5. Apparatus according to one of claims 1 to 4, **characterised in that** a concentration of said ionic salt(s) in said fluid (F) is greater than or equal to 0.18 mol/liter.

6. Apparatus according to one of claims 1 to 5, **characterised in that** the floor of each cell has an opening.

7. Apparatus according to one of claims 1 to 5, **characterised in that** said substrate surface (SS) comprises openings (OP) that couple each of said cell housing (OH) to a source (SM) of said medium (M).

8. Apparatus according to one of claims 1 to 7, **characterised in that** said medium (M) is a gas and/or a liquid.

9. Apparatus according to one of claims 1 to 8, **characterised in that** said fluid (F) is a liquid.

10. Method for controlling the flow resistance of a fluid (F) on a surface (SS) of a substrate (SU), said surface (SS) comprising a plurality of cells (C) comprising a lateral wall (LW) defining an open housing (OH) for holding a medium (M) therein and having at least one dimension that is less than the capillary length of a fluid-medium combination, said method **characterised by** defining a foam (FO) situated at the boundary of a fluid (F) and comprising fluid walls (FW) contacting said cells and defining at least partly bubbles (B) filled with said medium (M), **characterised** further in that one also adds molecules of at least one ionic salt to said fluid (F) and medium (M) in order that said fluid walls (FW) contain some of these added molecules, thus allowing to stabilise said bubbles (B).

11. Method according to claim 10, **characterised in that** one chooses each ionic salt from a group comprising at least NaCl, CuSO₄, AlCl₃, MgSO₄, MgCl₂, CaCl₂, Na₂SO₄, LiCl, NaBr and KCl.

12. Method according to one of claims 10 and 11, **characterised in that** one defines a foam (FO) comprising a quasi-static foam layer.

13. Method according to one of claims 10 and 11, **characterised in that** one defines a foam (FO) comprising a transient foam layer.

14. Method according to one of claims 10 to 13, **characterised in that** one adds a concentration of ionic salt(s) in said fluid (F) which is approximately equal to or greater than 0.18 mol/liter in the case of a NaCl aqueous solution.

15. Method according to one of claims 10 to 14, **characterised in that** one feeds each of said cell housing (OH) with said medium (M) through openings (OP) defined into said substrate surface (SS) and coupled to a source (SM) of said medium (M).

16. Method according to one of claims 10 to 15, **characterised in that** one uses a medium (M) which is a gas and/or a liquid.

17. Method according to one of claims 10 to 16, **characterised in that** one uses a fluid (F) which is a liquid.

## Patentansprüche

1. Vorrichtung (AP) zur Steuerung des Flusswiderstands eines Fluids, das über eine Oberfläche fließt, umfassend eine Mehrzahl von auf einer Oberfläche (SS) eines Substrats (SU) angeordnete Zellen (C), wobei eine jede der besagten Zellen eine seitliche Wand (LW) aufweist, welche ein offenes Gehäuse (OH) zur Aufnahme eines Mediums (M) darin definiert und mindestens eine Dimension aufweist, die kleiner ist als die Kapillarlänge einer Fluid-Medium-Kombination, **dadurch gekennzeichnet, dass** sie einen Schaum (FO) am Rande eines Fluids (F) und Fluidwände (FW), welche mit den besagten Zellen (C) in Berührung stehen und zumindest teilweise mit dem besagten Medium (M) gefüllte Blasen (B) definieren, umfasst, wobei die besagten Fluidwände (FW) gelöste Moleküle mindestens eines ionischen Salzes zum Stabilisieren der besagten Blasen (B) enthalten.

2. Vorrichtung nach Anspruch 1, **dadurch gekennzeichnet, dass** jedes ionische Salz in einer Gruppe bestehend aus mindestens NaCl, CuSO₄, AlCl₃, MgSO₄, MgCl₂, CaCl₂, Na₂SO₄, LiCl, NaBr und KCI gewählt wird.

3. Vorrichtung nach einem der Ansprüche 1 und 2, **dadurch gekennzeichnet, dass** der besagte Schaum (FO) eine quasistatische Schaumschicht umfasst.

4. Vorrichtung nach einem der Ansprüche 1 und 2, **dadurch gekennzeichnet, dass** der besagte Schaum (FO) eine transiente Schaumschicht umfasst.

5. Vorrichtung nach einem der Ansprüche 1 bis 4, **dadurch gekennzeichnet, dass** eine Konzentration der/des besagten Salze(s) in der besagten Flüssigkeit (F) größer als oder gleich 0,18 mol/Liter ist.

6. Vorrichtung nach einem der Ansprüche 1 bis 5, **dadurch gekennzeichnet, dass** der Boden einer jeden Zelle mit einer Öffnung versehen ist.

7. Vorrichtung nach einem der Ansprüche 1 bis 5, **dadurch gekennzeichnet, dass** die besagte Substratoberfläche (SS) Öffnungen (OP) aufweist, welche ein jedes der besagten Zellgehäuse (OH) an eine Quelle (SM) des besagten Mediums (M) koppeln.

8. Vorrichtung nach einem der Ansprüche 1 bis 7, **dadurch gekennzeichnet, dass** das besagte Medium (M) ein Gas und/oder eine Flüssigkeit ist.

9. Vorrichtung nach einem der Ansprüche 1 bis 8, **dadurch gekennzeichnet, dass** das besagte Fluid (F) eine Flüssigkeit ist.

10. Verfahren zur Steuerung des Flusswiderstands eines Fluids (F) auf einer Oberfläche (SS) eines Substrats (SU), wobei die besagte Oberfläche (SS) eine Mehrzahl von Zellen (C) mit einer seitlichen Wand (LW), welche ein offenes Gehäuse (OH) für die Aufnahme eines Mediums (M) darin umfasst, mit mindestens einer Dimension, welche kleiner ist als die Kapillarlänge einer Fluid-Medium-Kombination, wobei das besagte Verfahren **gekennzeichnet ist durch** das Definieren eines Schaums (FO) am Rande eines Fluids (F) und Fluidwände (FW) umfasst, welche mit den besagten Zellen in Berührung stehen und zumindest teilweise mit dem besagten Medium (M) gefüllte Blasen (B) definieren, weiterhin **dadurch gekennzeichnet, dass** man ebenfalls Moleküle mindestens eines ionischen Salzes zu dem besagten Fluid (F) und Medium (M) hinzufügt, so dass die besagten Fluidwände (FW) einige dieser hinzugefügten Moleküle enthalten, wodurch die Stabilisierung der besagten Blasen (B) gewährleistet wird.

11. Verfahren nach Anspruch 10, **dadurch gekennzeichnet, dass** man jedes ionische Salz in einer Gruppe bestehend aus mindestens NaCl, CuSO₄, AlCl₃, MgSO₄, MgCl₂, CaCl₂, Na₂SO₄, LiCl, NaBr und KCl wählt.

12. Verfahren nach einem der Ansprüche 10 und 11, **dadurch gekennzeichnet, dass** man einen Schaum (FO) mit einer quasistatischen Schaumschicht definiert.

13. Verfahren nach einem der Ansprüche 10 und 11, **dadurch gekennzeichnet, dass** man einen Schaum (FO) mit einer transienten Schaumschicht definiert.

14. Verfahren nach einem der Ansprüche 10 bis 13, **dadurch gekennzeichnet, dass** man eine Konzentration von ionische(m)(n) Salz(en) in dem besagten Fluid (F) hinzufügt, welche im Fall einer wässrigen NaCl-Lösung annähernd 0,18 mol/Liter entspricht oder größer ist.

15. Verfahren nach einem der Ansprüche 10 bis 14, **dadurch gekennzeichnet, dass** man das besagte Medium (M) über in der besagten Substratoberfläche (SS) definierte und an eine Quelle (SM) des besagten Mediums (M) gekoppelte Öffnungen (OP) in ein jedes der besagten Zellgehäuse (OH) einspeist.

16. Verfahren nach einem der Ansprüche 10 bis 15, **dadurch gekennzeichnet, dass** man ein Medium (M) verwendet, welches ein Gas und/oder eine Flüssigkeit ist.

17. Verfahren nach einem der Ansprüche 10 bis 16, **dadurch gekennzeichnet, dass** man ein Fluid (F) verwendet, welches eine Flüssigkeit ist.

## Revendications

1. Appareil (AP) pour réguler la résistance à l'écoulement d'un fluide qui passe sur une surface, comprenant une pluralité de cellules (C) disposées sur une surface (SS) d'un substrat (SU), chacune desdites cellules (C) comprenant une paroi latérale (LW) définissant un boîtier ouvert (OH) pour contenir un milieu (M) dans celui-ci et comprenant au moins une dimension qui est inférieure à la longueur capillaire d'une combinaison fluide-milieu, **caractérisé en ce qu'**il comprend une mousse (FO) située à la limite d'un fluide (F) et comprenant des parois de fluide (FW) en contact avec lesdites cellules (C) et définissant au moins partiellement des bulles (B) remplies avec ledit milieu (M), lesdites parois de fluide (FW) incluant des molécules dissoutes d'au moins un sel ionique pour stabiliser lesdites bulles (B).

2. Appareil selon la revendication 1, **caractérisé en ce que** chaque sel ionique est choisi dans un groupe comprenant au moins le NaCl, le CuSO₄, l'AlCl₃, le MgSO₄, le MgCl₂, le CaCl₂, le Na₂SO₄, le LiCl, le NaBr et le KCI.

3. Appareil selon l'une des revendications 1 et 2, **caractérisé en ce que** ladite mousse (FO) comprend une couche de mousse quasi-statique.

4. Appareil selon l'une des revendications 1 et 2, **caractérisé en ce que** ladite mousse (FO) comprend une couche de mousse transitoire.

5. Appareil selon l'une des revendications 1 à 4, **caractérisé en ce qu'**une concentration dudit/desdits sel(s) ionique(s) dans ledit fluide (F) est supérieure ou égale à 0,18 mol/litre.

6. Appareil selon l'une des revendications 1 à 5, **caractérisé en ce que** le fond de chaque cellule comprend une ouverture.

7. Appareil selon l'une des revendications 1 à 5, **caractérisé en ce que** ladite surface du substrat (SS) comprend des ouvertures (OP) qui connectent chacun desdits boîtiers de cellule (OH) à une source (SM) dudit milieu (M).

8. Appareil selon l'une des revendications 1 à 7, **caractérisé en ce que** ledit milieu (M) est un gaz et/ou un liquide.

9. Appareil selon l'une des revendications 1 à 8, **caractérisé en ce que** ledit fluide (F) est un liquide.

10. Procédé pour réguler la résistance à l'écoulement d'un fluide (F) sur une surface (SS) d'un substrat (SU), ladite surface (SS) comprenant une pluralité de cellules (C) comprenant une paroi latérale (LW) définissant un boîtier ouvert (OH) pour contenir un milieu (M) dans celui-ci et comprenant au moins une dimension qui est inférieure à la longueur capillaire d'une combinaison fluide-milieu, ledit procédé étant **caractérisé par** la définition d'une mousse (FO) située à la limite d'un fluide (F) et comprenant des parois de fluide (FW) en contact avec lesdites cellules et définissant au moins partiellement des bulles (B) remplies avec ledit milieu (M), **caractérisé en outre en ce que** des molécules d'au moins un sel ionique sont également ajoutées audit fluide (F) et milieu (M) afin que lesdites parois de fluide (FW) contiennent certaines de ces molécules ajoutées, permettant ainsi la stabilisation desdites bulles (B).

11. Procédé selon la revendication 10, **caractérisé en ce que** le sel ionique est choisi dans un groupe comprenant au moins le NaCl, le CuSO₄, l'AlCl₃, le MgSO₄, le MgCl₂, le CaCl₂, le Na₂SO₄, le LiCl, le NaBr et le KCl.

12. Procédé selon l'une des revendications 10 et 11, **caractérisé en ce qu'**une mousse (FO) est définie, laquelle comprend une couche de mousse quasi-statique.

13. Procédé selon l'une des revendications 10 et 11, **caractérisé en ce qu'**une mousse (FO) est définie, laquelle comprend une couche de mousse transitoire.

14. Procédé selon l'une des revendications 10 à 13, **caractérisé en ce qu'**une concentration de sel(s) ionique(s) est ajoutée dans ledit fluide (F), laquelle est approximativement égale ou supérieure à 0,18 mol/litre dans le cas d'une solution aqueuse de NaCl.

15. Procédé selon l'une des revendications 10 à 14, **caractérisé en ce que** chacun desdits boîtiers de cellule (OH) est alimenté avec ledit milieu (M) à travers des ouvertures (OP) définies dans ladite surface du substrat (SS) et connectées à une source (SM) dudit milieu (M).

16. Procédé selon l'une des revendications 10 à 15, **caractérisé par** l'utilisation d'un milieu (M) qui est un gaz et/ou un liquide.

17. Procédé selon l'une des revendications 10 à 16, **caractérisé par** l'utilisation d'un fluide (F) qui est un liquide.
